Europäisches Patentamt

European Patent Office

Office européen des brevets

(19)

(11) Veröffentlichungsnummer : **0 062 100**
**B1**

(12) **EUROPÄISCHE PATENTSCHRIFT**

(45) Veröffentlichungstag der Patentschrift :
06.05.87

(21) Anmeldenummer : 81108715.4

(22) Anmeldetag : 22.10.81

(51) Int. Cl.⁴ : **H 01 L 29/743**, H 01 L 29/08

(54) **Thyristor mit innerer Stromverstärkung und Verfahren zu seinem Betrieb.**

(30) Priorität : 31.03.81 DE 3112941

(43) Veröffentlichungstag der Anmeldung :
13.10.82 Patentblatt 82/41

(45) Bekanntmachung des Hinweises auf die Patenterteilung : 06.05.87 Patentblatt 87/19

(84) Benannte Vertragsstaaten :
**CH FR GB IT LI SE**

(56) Entgegenhaltungen :
**EP-A- 0 028 798**
**EP-A- 0 029 163**
**DE-A- 2 947 669**
**DE-B- 1 439 922**
**E. Spenke:" pn-Übergänge", Springer-Verlag, Berlin**
**1979, S. 123+124**

(73) Patentinhaber : **Siemens Aktiengesellschaft Berlin
und München
Wittelsbacherplatz 2
D-8000 München 2 (DE)**

(72) Erfinder : **Herberg, Helmut, Dr.
Kobellstrasse 12
D-8000 München 2 (DE)**

EP 0 062 100 B1

## Beschreibung

Die Erfindung bezieht sich auf einen Thyristor mit innerer Stromverstärkung nach dem Oberbegriff des Patentanspruchs 1 und auf ein Verfahren zu seinem Betrieb.

Ein Thyristor dieser Art ist aus dem Buch « pn-Übergänge » von E. Spenke, erschienen im Springer-Verlag, Berlin 1979, Seiten 123 und 124, vgl. insbesondere Abb. 16.15, bekannt. Der Hilfsemitter, der dort als « amplifying gate » bezeichnet ist, wird bei der Zündung des Thyristors von einem Strom durchflossen, der eine schnelle und großflächige Zündung im Bereich des Hauptemitters bewirkt. Wegen des schnellen Ablaufs des gesamten Zündvorgangs ist ein Thyristor dieser Art für große Anstiegsgeschwindigkeiten des zwischen Anode und Kathode fließenden Laststroms geeignet, d. h. er weist eine große di/dt-Festigkeit auf.

In der europäischen Patentanmeldung EP-A2-0 028 798, die gemäß Artikel 54(3) EPÜ zu berücksichtigen ist, ist ein Thyristor mit innerer Stromverstärkung beschrieben, bei dem der Hauptemitter mehrere feste Emitter-Kurzschlüsse aufweist, während der Hilfsemitter mit Emitter-Kurzschlüssen versehen ist, die mittels FET-Strukturen wahlweise wirksam schaltbar, d. h. steuerbar, sind. Sind sie wirksam geschaltet, so weist der Thyristor eine gute Stabilität auf, d. h. eine große Sicherheit gegen unbeabsichtigte Zündvorgänge beim Auftreten von in Durchlaßrichtung gepolten Spannungen, die unter Umständen sehr schnell ansteigen, d. h. eine hohe dU/dT-Belastung darstellen. Andererseits ist der Thyristor bei unwirksam geschalteten Kurzschlüssen zündempfindlich.

Schließlich ist aus der DE-A-2 947 669 (Fig. 4) ein Thyristor bekannt, bei dem der n-Emitter mit steuerbaren Emitter-Kurzschlüssen zur Verbesserung des dU/dT-Verhaltens versehen ist. Ein solcher Emitter-Kurzschluß besteht aus einem Randbereich des n-Emitters, aus einem in die angrenzende p-Basisschicht eingefügten n-leitenden Kurzschlußgebiet, das über eine leitende Belegung mit der p-Basis verbunden ist, und aus einem von einer Gate-Elektrode überdeckten Halbleiterbereich, der durch einen Teilbereich der p-Basisschicht gebildet wird. Ein Hilfsemitter ist jedoch bei diesem Thyristor nicht vorgesehen.

Der Erfindung liegt die Aufgabe zugrunde, einen Thyristor der eingangs genannten Art anzugeben, der trotz eines einfachen Aufbaues die sich widersprechenden Forderungen nach einer guten Stabilität und einer großen Zündempfindlichkeit weitgehend erfüllt. Das wird erfindungsgemäß durch eine Ausbildung des Thyristors gemäß dem kennzeichnenden Teil des Patentanspruchs 1 erreicht.

Der mit der Erfindung erzielbare Vorteil liegt insbesondere darin, daß der anschaltbare Hilfsemitter einerseits im nichtleitenden Zustand des Halbleiterschalters unwirksam ist und die Stabilität des Thyristors nicht verringert, während er andererseits im leitenden Zustand des Halbleiterschalters die Zündempfindlichkeit des Thyristors wesentlich vergrößert. Im einzelnen steigt die Zündempfindlichkeit in dem Maße, in dem der Stromverstärkungsfaktor der Struktur, die den anschaltbaren Hilfsemitter und die beiden Basisschichten umfasst, bezüglich der vom anschaltbaren Hilfsemitter emittierten Ladungsträger größer ist als der entsprechende Stromverstärkungsfaktor der Struktur, die den Hilfsemitter und die beiden Basisschichten umfasst.

Die Patentansprüche 2 bis 11 sind auf bevorzugte Ausgestaltungen und Weiterbildungen der Erfindung gerichtet, während die Patentansprüche 12 und 13 vorteilhafte Verfahren zum Betrieb des erfindungsgemäßen Thyristors angeben.

Die Erfindung wird nachfolgend anhand der Zeichnung näher beschrieben. Dabei zeigt :

Figur 1 den Querschnitt eines ersten Ausführungsbeispiels der Erfindung,

Figur 2 den Querschnitt eines zweiten Ausführungsbeispiels,

Figur 3 den Querschnitt eines dritten Ausführungsbeispiels,

Figur 4 den Querschnitt eines vierten Ausführungsbeispiels und

Figur 5 die schematische Darstellung einer alternativen Ausführungsform zu Fig. 1.

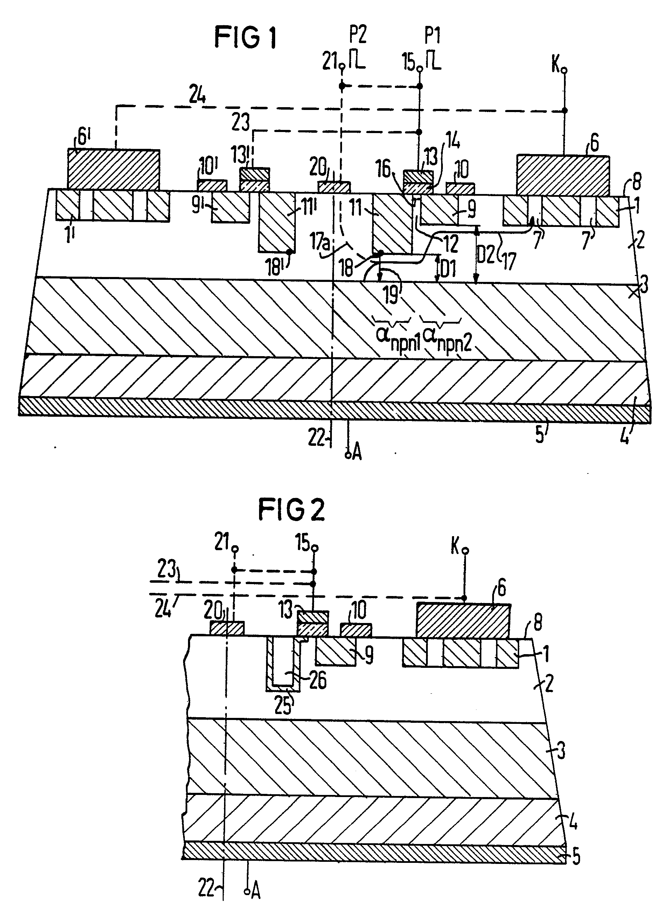

In Fig. 1 ist ein Thyristor dargestellt, der einen aus dotiertem Halbleitermaterial, z. B. Silizium, bestehenden Halbleiterkörper mit vier Schichten abwechselnder Leitungstypen aufweist. Dabei bezeichnet man die n-leitende Schicht 1 als den n-Emitter, die p-leitende Schicht 2 als die p-Basis, die n-leitende Schicht 3 als die n-Basis und die p-leitende Schicht 4 als den p-Emitter. Der p-Emitter 4 ist mit einer Anode 5 versehen, die einen Anschluß A hat, während der n-Emitter 1 eine Kathode 6 mit einem Anschluß K aufweist.

Der n-Emitter 1, der den Hauptemitter darstellt, wird von mehreren Ansätzen 7 der p-Basis 2 durchdrungen, die sich bis zur Grenzfläche 8 des Halbleiterkörpers erstrecken und in dieser mit der Kathode 6 leitend verbunden sind. Die Ansätze 7 stellen sog. feste Emitter-Kurzschlüsse dar, die eine unbeabsichtigte Zündung des Thyristors beim Anlegen einer Blockierspannung an die Anschlüsse A und K, die die Anode 5 auf ein positiveres Potential legt als die Kathode 6, weitgehend verhindern. Dies erklärt sich daraus, daß die unter dem Einfluß der Blockierspannung in Richtung auf den n-Emitter 1 transportierten Defektelektronen zum größten Teil nicht zu dem pn-Übergang zwischen den Teilen 1 und 2 gelangen, sondern über die Ansätze 7 direkt zur Kathode 6, so daß sie keine Emission von Elektronen aus dem n-Emitter 1 auslösen. Mit wachsender Anzahl der festen Emitterkurzschlüsse 7 ist der Thyristor auch gegenüber größeren oder schnell ansteigenden Blockierspannungen an den Anschlüssen A, K zündunempfindlich, d. h.

stabil.

Ein n-leitendes Gebiet 9, das den ersten Hilfsemitter darstellt, ist in die p-Basis 2 so eingefügt, daß es sich bis zur Grenzfläche 8 hin erstreckt. In dieser wird es von einer Hilfsemitterelektrode 10 kontaktiert, die den pn-Übergang zwischen dem Gebiet 9 und der p-Basis 2 in Richtung auf den n-Emitter 1 leitend überbrückt.

Ein weiteres n-leitendes Gebiet 11 erstreckt sich, ausgehend von der Grenzfläche 8, wesentlich tiefer in die P-Basis 2 hinein als der n-Emitter 1 und der Hilfsemitter 9 und wird durch eine Diffusion oder Implantation und anschließendes Eintreiben von Donatoren in die p-Basis 2 erzeugt. Es ist lateral neben dem Hilfsemitter 9 angeordnet, wobei zu diesem ein Abstand besteht, der durch die Breite eines Bereichs 12 der p-Basis 2 bestimmt ist. Der Bereich 12 wird durch ein metallisches oder aus Polysilizium bestehendes Gate 13 überdeckt, das durch eine dünne, elektrisch isolierende Schicht 14, z. B. aus $SiO_2$, von der Grenzfläche 8 getrennt ist. Das Gate 13 ist mit einem Steuerspannungsanschluß 15 verbunden. Die einander zugekehrten Randbereiche des Hilfsemitters 9 und des Gebiets 11 bilden zusammen mit dem Bereich 12, der isolierenden Schicht 14 und dem Gate 13 einen Feldeffekttransistor des Anreicherungstyps. Beim Anlegen einer gegenüber K positiven, den Wert der Einsatzspannung übersteigenden Steuerspannung an den Anschluß 15 bildet sich an der Grenzfläche 8 unterhalb von 13 ein Inversionskanal, der mit 16 angedeutet ist. Dieser n-leitende Kanal stellt eine niederohmige Verbindung zwischen den Gebieten 9 und 11 dar. Wird die Steuerspannung vom Anschluß 15 abgeschaltet, so wird der Kanal 16 beseitigt und die Verbindung zwischen den Gebieten 9 und 11 unterbrochen. Die aus den Teilen 9 bis 16 gebildete Struktur stellt also einen Halbleiterschalter dar, der in einem ersten Schaltzustand das Gebiet 11 niederohmig mit dem Hilfsemitter 9 verbindet, so daß ein vergrößerter Hilfsemitter 9, 11 entsteht, während er in einem zweiten Schaltzustand das Gebiet 11 von dem Hilfsemitter 9 abtrennt, so daß 11 keine Hilfsemitterfunktion ausüben kann. Im folgenden wird das Gebiet 11 als anschaltbarer zweiter Hilfsemitter bezeichnet.

Ausgehend von der Grenzfläche 8 beträgt die Eindringtiefe des anschaltbaren Hilfsemitters 11 in die p-Basis 2 bei dem in Fig. 1 dargestellten Ausführungsbeispiel mehr als das Doppelte der Eindringtiefe des Hilfsemitters 9 bzw. der des n-Emitters 1. Nimmt man für den Hilfsemitter 9 eine Eindringtiefe von etwa 20 μm an, so beträgt die Eindringtiefe von 11 beispielsweise 50 μm. Dementsprechend ist der Abstand D1 des anschaltbaren Hilfsemitters 11 von pn-Übergang zwischen den Basisschichten 2 und 3 kleiner als der Abstand D2 des Hilfsemitters 9 bzw. des n-Emitters 1 von diesem Übergang.

Nachfolgend wird die Zündung des Thyristors nach Fig. 1 erläutert. Dabei wird davon ausgegangen, daß eine den Thyristor in Durchlaßrichtung polende Spannung an den Anschlüssen A und K liegt und dem Anschluß 15 eine positive Steuerspannung zugeführt wird. Unter dem Einfluß der erstgenannten Spannung bewegen sich beispielsweise thermisch erzeugte Defektelektronen längs des in Fig. 1 eingezeichneten Weges 17 in Richtung auf einen festen Emitterkurzschluß 7, so daß bei leitendem Kanal 16 am Punkt 18 ein Spannungsabfall entsteht, der den pn-Übergang zwischen dem angeschalteten Hilfsemitter 11 und der p-Basis 2 soweit in Durchlaßrichtung vorspannt, daß an dieser Stelle Elektronen in die p-Basis 2 emittiert werden. Die von 11 emittierten Elektronen bewegen sich in Richtung des Pfeils 19, wobei ein Teil von ihnen die Grenzfläche zwischen der n-Basis 3 und dem p-Emitter 4 erreicht und eine Emission von Defektelektronen aus dem p-Emitter veranlaßt. Diese Emissionsvorgänge steigern sich gegenseitig, bis die Schichten 2 und 3 von emittierten Ladungsträgern überschwemmt sind, d. h. der Thyristor im Bereich des anschaltbaren Hilfsemitters 11 gezündet hat. Der von A über den Hilfsemitter 9, 11 und die Hilfsemitterelektrode 10 zum n-Emitter 1 und zur Kathode 6 fließende Laststrom stellt dabei einen großen Zündstrom für den n-Emitter 1 dar.

Sobald sich die gezündete Fläche des Thyristors von 11 ausgehend in lateraler Richtung so weit ausgebreitet hat, daß sie den Bereich des n-Emitters 1 wenigstens teilweise mitumfasst, wird der zwischen A und K fließende Laststrom vollständig von dem Teil des Thyristorquerschnitts übernommen, der den gezündeten Teil des n-Emitters 1 enthält. Der Hilfsemitter 9 wird dann nicht mehr vom Laststrom durchflossen. Dem Anschluß 15 kann also eine impulsförmige Steuerspannung P1 zugeführt werden, die dann abgeschaltet wird, wenn der Thyristorquerschnitt im Bereich des n-Emitters 1 stromführend geworden ist.

Für den Fall, daß eine Zündelektrode 20 auf der p-Basis 2 angeordnet ist, erfolgt die Zündung des Thyristors bei kleineren Spannungen zwischen A und K, als bei den vorstehenden Betrachtungen angenommen wurde, mittels eines Zündstromimpulses P2, der über einen bei 21 angeschlossenen Zündstromkreis zugeführt wird. Die Vorspannung am Schaltungspunkt 18 wird hierbei von Defektelektronen erzeugt, die aus dem Halbleiterbereich unterhalb der Zündelektrode 20 stammen und über die in Fig. 1 eingezeichneten Wege 17a und 17 zu einem festen Kurzschluß 7 gelangen. Dabei wird der Anschluß 15 gleichzeitig mit der Steuerspannung P1 beschaltet. Zweckmäßigerweise werden die Anschlüsse 15 und 21 miteinander verbunden, wobei der Zündstromimpuls P2 am Anschluß 15 den Spannungsimpuls P1 abfallen läßt.

Der Thyristor wird gelöscht, wenn der Laststrom einen sogenannten Haltestrom unterschreitet. Das geschieht beispielsweise, wenn die Spannung von den Anschlüssen A und K abgeschaltet wird, oder, wenn es sich um eine Wechselspannung handelt, beim Auftreten des nächstfolgenden Nulldurchgangs.

Die große Zündempfindlichkeit des Thyristors nach Fig. 1 ergibt sich aus dem kleinen Abstand D1 zwischen dem anschaltbaren Hilfsemitter 11 und der Grenzfläche zwischen den Schichten 2 und 3. Der Stromverstärkungsfaktor $\alpha_{npn1}$ der aus den Teilen 11, 2 und 3 gebildeten npn-Struktur, der sich auf die von 11 emittierten Elektronen bezieht, ist wesentlich größer als der Stromverstärkungsfaktor $\alpha_{npn2}$ für die aus den Teilen 9, 2 und 3 gebildete npn-Struktur. Dies erklärt sich daraus, daß die Rekombinationsrate der von 9 emittierten Elektronen wegen des größeren Abstands D2 des Hilfsemitters 9 von der Grenzfläche zwischen 2 und 3 wesentlich größer ist als die Rekombinationsrate der von 11 emittierten Elektronen. Die Zündempfindlichkeit des Thyristors nach Fig. 1 ist also in dem Maße größer als die Zündempfindlichkeit eines herkömmlichen Thyristors mit innerer Zündverstärkung, als der Stromverstärkungsfaktor $\alpha_{npn1}$ größer ist als $\alpha_{npn2}$.

Weist die p-Basis 2 ein Dotierungsprofil auf, bei dem der Dotierungsgrad im Bereich der unteren Begrenzungsfläche des anschaltbaren Hilfsemitters 11 kleiner ist als an der unteren Begrenzungsfläche des Hilfsemitters 9, so wird die am Punkt 18 herrschende Vorspannung des pn-Übergangs zwischen den Halbleiterteilen 11 und 2 gegenüber dem Fall, bei dem der Dotierungsgrad der p-Basis eine solche Verkleinerung nicht aufweist, weiter vergrößert, so daß die Zündempfindlichkeit im Bereich des anschaltbaren Hilfsemitters 11 weiter ansteigt.

Bisher wurde aus Gründen der besseren Übersicht das Erfindungsprinzip anhand des in Fig. 1 rechts von der vertikalen Mittellinie 22 liegenden Teils des Dargestellten Thyristors erläutert. Geht man nun in Fig. 1 von einem rotationssymmetrischen Aufbau des Thyristors mit der Linie 22 als Symetrieachse aus, so ergeben sich ringförmige Ausgestaltungen der Teile 1, 9, 11, 6, 10 und 13. Die Schnittflächen dieser Teile, die links von 22 liegen, sind mit 1', 9', 11', 6', 10' und 13' bezeichnet. Die Zündung einer solchen Struktur erfolgt längs eines zur Achse 22 konzentrischen Kreises, der die Punkte 18 und 18' enthält.

Andererseits kann die Linie 22 in Fig. 1 auch als eine senkrecht zur Bildebene stehende Symmetrieebene aufgefasst werden. Dabei weisen die Teile 1, 9, 11, 6, 10 und 13 zweckmäßigerweise eine langgestreckte Form auf und verlaufen mit ihren größeren Abmessungen senkrecht zur Zeichenebene, und zwar vorzugsweise über den ganzen Thyristorquerschnitt. Die Teile 1', 9', 11', 6', 10' und 13' stellen dann analoge Teilstrukturen auf der anderen Seite der Symmetrieebene dar, die bezüglich der letzteren symmetrisch zu den Teilen 1, 9, 11, 6, 10 und 13 liegen. Die Gates 13 und 13' sind in diesem Fall zum Zwecke einer gemeinsamen Ansteuerung miteinander verbunden, was durch eine eingezeichnete Leitung 23 angedeutet ist, und können an den Anschluß 21 geführt sein. Die Kathode 6' ist mit der Kathode 6 verbunden, was durch eine Leitung 24 angedeutet ist.

Die Teile 1, 9, 11, 6, 10 und 13 können mit Vorteil auch streifenförmig ausgebildet und den Thyristorquerschnitt oder Teile davon in Form einer Spirale oder dergl. überdecken. Bei dem in Fig. 2 dargestellten Ausführungsbeispiel ist ein anschaltbarer Hilfsemitter 25 vorgesehen, der an die Stelle des anschaltbaren Hilfsemitters 11 von Fig. 1 tritt und die gleichen äußeren Abmessungen gegenüber der p-Basis 2 aufweist wie dieser. Er ist an den Randzonen einer grabenförmigen Ausnehmung 26 der p-Basis 2 vorgesehen, wobei er sich ausgehend vom Rand derselben nur wenige μm, z. B. 5 μm, tief in die p-Basis 2 erstreckt. Dabei wird das n-leitende Gebiet 25 durch Diffusion oder Implantation von Donatoren erzeugt, während die Ausnehmung 26 vorzugsweise durch Ätzung hergestellt wird. Die übrigen Schaltungsteile von Fig. 2 entsprechen den gleichbezeichneten Schaltungsteile von Fig. 1.

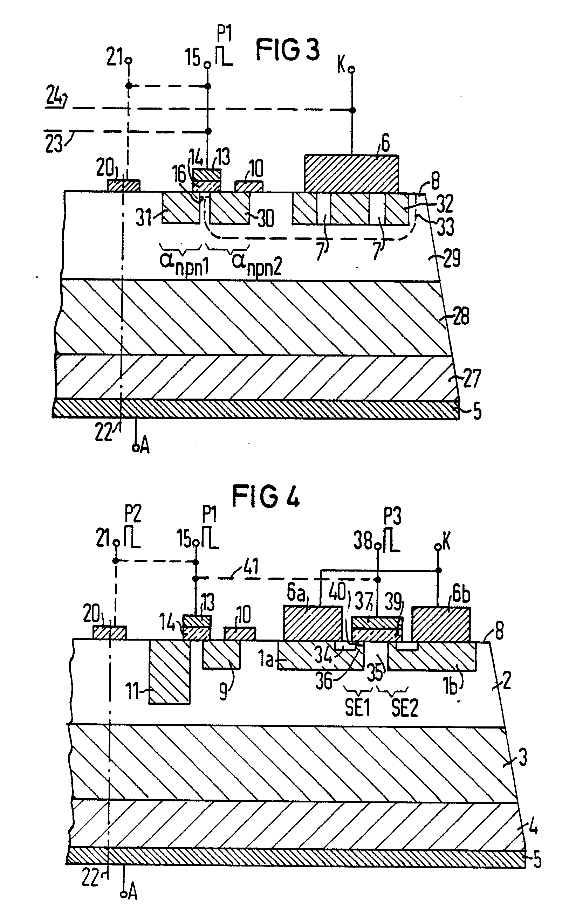

In Fig. 3 ist ein Thyristor mit einem p-Emitter 27, einer n-Basis 28 und einer p-Basis 29 dargestellt. Ein Hilfsemitter 30 und ein anschaltbarer Hilfsemitter 31 treten hierbei an die Stelle der Teile 9 und 11 von Fig. 1 und weisen die gleichen lateralen Abmessungen gegenüber der p-Basis 29 auf wie die Teile 9 und 11 gegenüber der p-Basis 2. Mit 32 ist ein n-Emitter bezeichnet, der an die Stelle des n-Emitters 1 von Fig. 1 tritt und die gleichen lateralen Abmessungen aufweist wie dieser. Die vertikalen Abmessungen der Teile 30 bis 32 sind einander angeglichen, wobei sie zweckmäßigerweise größer sind als die vertikale Abmessung des n-Emitters 1 und beispielsweise denen der Teile 11 und 11' in Fig. 1 entsprechen. Die übrigen Schaltungsteile von Fig. 3 entsprechen den mit gleichen Bezugszeichen versehenen Schaltungsteilen von Fig. 1.

Der n-Emitter 32 und der Hilfsemitter 30 sind von einem Teilbereich 33 der p-Basis 29 umgeben, der ein zusätzliche p-Dotierung aufweist, so daß sein Dotierungsgrad höher ist als der der übrigen Teilbereiche der p-Basis 29. Das hat zur Folge, daß die aus den Teilen 30, 29 und 28 bestehende Drei-Schichten-Struktur einen Stromverstärkungsfaktor $\alpha_{npn2}$ bezüglich der im Falle einer bei A und K in Durchlaßrichtung des Thyristors angelegten Spannung vom Teil 30 emittierten Elektronen aufweist, der kleiner ist als der entsprechende Stromverstärkungsfaktor $\alpha_{npn1}$ der Drei-Schichten-Struktur 31, 29 und 28 bezüglich der von dem anschaltbaren Hilfsemitter 31 emittierten Elektronen. Je stärker sich der Dotierungsgrad des Teilbereichs 33 von dem der übrigen Teilbereiche der p-Basis 29 unterscheidet, desto stärker weichen $\alpha_{npn1}$ und $\alpha_{npn2}$ voneinander ab. Wird dem Anschluß 15 eine Steuerspannung, z. B. P1, zugeführt, die es bewirkt, daß die Gebiete 30 und 31 über den mit 16 angedeuteten Inversionskanal niederohmig miteinander verbunden werden, so wird der Thyristor im Bereich des Gebiets 31 sehr zündempfindlich. Bei Abschaltung der Steuerspannung vom Anschluß 15 ist der Hilfsemitter 31 unwirksam, so daß der Thyristor wegen der festen Emitterkurzschlüsse 7 und der hohen Dotierung des Teilbereichs 33 eine große Stabilität aufweist. Bei einer Störstellenkonzentration in der p-Basis 29 von etwa $5 \times 10^{16}$ cm$^{-3}$ kommt für den Teilbereich 33 beispielsweise eine Störstellenkonzentration von etwa $2 \times 10^{17}$ cm$^{-3}$ in Betracht, wobei diese Zahlenangaben nur zur Erläuterung des genannten Dotierungsunterschiedes dienen und nicht als Grenzwerte aufzufassen sind.

Unterschiedliche Stromverstärkungsfaktoren $\alpha_{npn1}$ und $\alpha_{npn2}$ lassen sich auch in der Weise erreichen, daß der Teilbereich 33 nicht stärker dotiert wird als die übrigen Teile des p-Emitters 29, sondern stattdessen mit zusätzlichen Rekombinationszentren versehen wird. Dies geschieht z. B. durch eine auf den Teilbereich 33 beschränkte Bestrahlung der p-Basis 29 vor dem Erzeugen der Gebiete 32 und 30 mit einem Elektronenstrahl. Andererseits können auch Rekombinationszentren in Form von Gold- oder Platinatomen durch Diffusion oder Implantation in den Teilbereich 33 eingebracht werden. Die Erhöhung der Anzahl der Rekombinationszentren im Teilbereich 33 bewirkt eine Verringerung von $\alpha_{npn2}$ gegenüber $\alpha_{npn1}$.

Die Thyristoren nach den Figuren 2 und 3 werden in derselben Weise betrieben wie der Thyristor nach Fig. 1.

Das in Fig. 4 dargestellte Ausführungsbeispiel unterscheidet sich von Fig. 1 dadurch, daß anstelle der festen Emitterkurzschlüsse 7 steuerbare Emitterkurzschlüsse vorgesehen sind. Der ·n-Emitter 1 von Fig. 1 ist in zwei oder mehrere Emitterteilgebiete 1a, 1b unterteilt, von denen jedes mit einem Teil 6a bzw. der Kathode versehen ist. Die Teile 6a und 6b sind miteinander verbunden und an einen gemeinsamen Anschluß K geführt.

Ein in Fig. 4 mit SE1 bezeichneter steuerbarer Emitterkurzschluß weist ein in das Emitterteilgebiet 1a eingefügtes, p-leitendes Halbleitergebiet 34 auf, das sich bis zur Grenzfläche 8 des Halbleiterkörpers erstreckt und in dieser von dem Teil 6a der Kathode kontaktiert wird. Die Emitterteilgebiete 1a und 1b sind durch einen Bereich 35 der p-Basis 2 voneinander getrennt, der als ein zweites p-leitendes Halbleitergebiet des steuerbaren Emitterkurzschlusses aufzufassen ist. Zwischen den Gebieten 34 und 35 liegt ein von der Grenzfläche 8 ausgehender Randbereich 36 des Emitterteilgebiets 1a, der n-leitend ist. Letzterer wird von einem Gate 37 überdeckt, das einen Anschluß 38 aufweist und von einer dünnen, elektrisch isolierenden Schicht 39, z. B. aus SiO$_2$, von dem Halbleiterkörper getrennt ist. Die Teile 34 bis 37 bilden eine FET-Struktur des Verarmungstyps, bei der ohne Zuführung einer Steuerspannung an den Anschluß 38 ein p-leitender Kanal 40 in dem Randbereich 36 besteht, der das Gebiet 34 mit dem Bereich 35 und damit den Teil 6a der Kathode mit der p-Basis 2 niederohmig verbindet. Der Kanal 40 ist entweder ein Inversionskanal oder ein durch eine p-Dotierung an der Grenzfläche 8 erzeugter, dotierter Kanal. Der Emitterkurzschluß SE1 ist also bei spannungsfreiem Anschluß 38 wirksam geschaltet. Führt man dem Anschluß 38 eine positive Steuerspannung zu, so wird der Kanal 40 beseitigt und die niederohmige Verbindung der Teile 2 und 6a unterbrochen, d. h. der Emitterkurzschluß SE1 unwirksam geschaltet.

In Fig. 4 ist randseitig zu dem Emitterteilgebiet 1b ein weiterer steuerbarer Emitterkurzschluß SE2 vorgesehen, der entsprechend SE1 aufgebaut ist. Dabei ist das Gate 37 den Emitterkurzschlüssen SE1 und SE2 gemeinsam zugeordnet. Zweckmäßigerweise ist eine mit 41 bezeichnete, die Anschlusse 38 und 15 untereinander verbindende Leitung vorgesehen. Die Anschlüsse 15 und 38 können auch einzeln oder gemeinsam mit dem Anschluß 21 verbunden sein. Die übrigen Schaltungsteile von Fig. 4 entsprechen den mit den gleichen Bezugszeichen versehenen Teilen von Fig. 1.

Anstelle der beiden dargestellten Emitterteilgebiete 1a und 1b können bei dem Ausführungsbeispiel von Fig. 4 auch mehrere entsprechend ausgebildete Emitterteilgebiete oder auch nur ein einziges solches Teilgebiet, z. B. 1a oder 1b, vorgesehen sein.

Mit dem Ausführungsbeispiel nach Fig. 4 wird eine besonders hohe Stabilität erreicht, und zwar insb. dann, wenn eine größere Anzahl von Emitterteilgebieten 1a, 1b ... und eine entsprechend große Anzahl von steuerbaren Emitterkurzschlüssen SE1, SE2 ... vorgesehen sind. Diese werden durch eine zum Zündzeitpunkt am Anschluß 38 liegende positive Steuerspannung, z. B. impulsförmige Steuerspannung P3, unwirksam geschaltet, so daß die Ausbreitung der gezündeten Front über den gesamten Thyristorquerschnitt durch die Emitterkurzschlüsse nicht behindert wird. Ist der Thyristorquerschnitt im Bereich der Emitterteilgebiete 1a, 1b stromführend geworden, kann die Steuerspannung abgeschaltet werden, wie durch P3 angedeutet ist. Ist ein Anschluß 21 vorgesehen, dem ein Zündstromimpuls P2 zugeführt wird, so kann der Anschluß 38 mit 21 verbunden werden, um die an 21 abfallende Spannung als Steuerspannung P3 verwenden zu können. Die Steuerung des Anschlusses 15 erfolgt in der bereits anhand von Fig. 1 erläuterten Weise.

Die bisher beschriebenen FET-Strukturen, z. B. 34 bis 40, des Verarmungstyps können auch durch FET-Strukturen des Anreicherungstyps ersetzt sein, wenn ihren Gateanschlüssen, z. B. 38, eine zusätzliche negative Steuerspannung zugeführt wird, die Inversionskanäle, z. B. 40, entstehen läßt. Dieser zusätzlichen Steuerspannung wird dann die Steuerspannung P3 im Zündzeitpunkt überlagert, um die Kanäle aufzuheben.

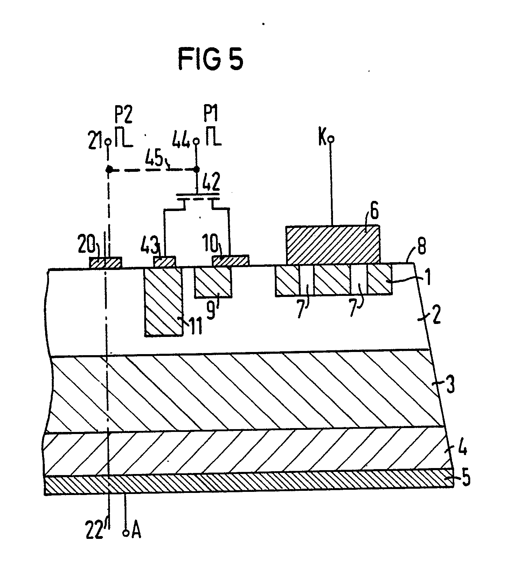

Fig. 5 zeigt eine andere Ausgestaltung des Ausführungsbeispiels nach Fig. 1, bei der der anschaltbare Hilfsemitter 11 über einen Halbleiterschalter in Form eines externen Feldeffekttransistors 42 mit dem Hilfsemitter 9 leitend verbunden wird. Dabei ist die Source-Drain-Strecke von 42 einerseits mit der Hilfsemitterelektrode 10 und andererseits mit einer leitenden Belegung 43 verbunden, die den anschaltbaren Hilfsemitter 11 kontaktiert. Das Gate von 42 ist mit einem Steuerspannungsanschluß 44 versehen, der über eine Leitung 45 mit dem Anschluß 21 verbunden werden kann. Der Betrieb des Thyristors nach Fig. 5 erfolgt in der anhand von Fig. 1 beschriebenen Weise, wobei der Anschluß 44 dem Anschluß 15 entspricht und mit der Steuerspannung P1 belegt ist, während dem Anschluß 21 gegebenenfalls ein Zündstromimpuls P2 zugeführt wird. Im Rahmen der Erfindung kann der anschaltbare Hilfsemitter auch p-leitend sein, lateral neben dem p-Emitter in den n-Basis des Thyristors angeordnet sein und zur Herstellung einer großen Zündempfindlichkeit über einen Halbleiterschalter mit diesem p-Emitter niederohmig verbunden werden. In diesem Fall sind dann auch die festen oder steuerbaren Emitterkurzschlüsse im Bereich des p-Emitters vorgesehen. Sämtliche Figuren können zur Darstellung dieser Schaltungsvariante herangezogen werden, wenn die Bezeichnungen der Anschlüsse A und K miteinander vertauscht werden, die Halbleiterteile jeweils die entgegengesetzten Leitungstypen zu den bisher beschriebenen erhalten und die genannten Steuerspannungen sowie der Steuerstrom mit entgegengesetzter Polarität zugeführt werden.

Sämtliche Ausführungsbeispiele nach den Figuren 2 bis 5 können jeweils zu einer Symmetrieachse 22 entsprechend Fig. 1 zentrisch symmetrisch ausgebildet sein oder jeweils zu einer Ebene, die auf die Bildebene senkrecht steht, und durch 22 angedeutet ist, symmetrisch aufgebaut sein.

Die Ausführungsbeispiele nach den Figuren 2, 3 und 4 können auch mit einem Halbleiterschalter in Form eines externen Transistors ausgestattet sein. Weiterhin können die anschaltbaren Hilfsemitter 11 der Figuren 4 und 5 entsprechend den Teilen 25, 26 von Fig. 2 ausgebildet sein, und die festen Emitterkurzschlüsse 7 in allen Figuren durch steuerbare Emitterkurzschlüsse, z. B. SE1 oder SE2, ersetzt sein.

## Patentansprüche

1. Thyristor mit einem Halbleiterkörper, der einen von einer Kathode (6) kontaktierten n-Emitter (1), einen von einer Anode (5) kontaktierten p-Emitter (4) und zwei jeweils an einen der Emitter und aneinander angrenzende Basisschichten (2, 3) unterschiedlichen Leitfähigkeitstyps enthält, und der einen zur inneren Zündverstärkung dienenden ersten Hilfsemitter (9) aufweist, der mit den beiden Basisschichten (2, 3) eine npn- oder pnp-Struktur bildet, dadurch gekennzeichnet, daß ein anschaltbarer zweiter Hilfsemitter (11) vorgesehen ist, der über einen Halbleiterschalter (9, 11, 13, 14, 15, 16) mit dem ersten Hilfsemitter (9) leitend verbindbar ist, und daß der anschaltbare zweite Hilfsemitter (11) mit den beiden Basisschichten (2, 3) eine npn- oder pnp-Struktur bildet, deren im leitenden Zustand des Halbleiterschalters und beim Anliegen einer Blockierspannung bestehender Stromverstärkungsfaktor ($\alpha_{npn1}$), bezogen auf die von dem anschaltbaren zweiten Hilfsemitter (11) emittierten Ladungsträger, größer ist als der entsprechende Stromverstärkungsfaktor ($\alpha_{npn2}$) der npn- oder pnp-Struktur, die aus dem ersten Hilfsemitter (9) und den beiden Basisschichten (2, 3) gebildet ist.

2. Thyristor nach Anspruch 1, dadurch gekennzeichnet, daß der Abstand (D1) des anschaltbaren zweiten Hilfsemitters (11) von dem zwischen den beiden Basisschichten (2, 3) bestehenden pn-Übergang kleiner ist als der Abstand (D2) des ersten Hilfsemitters (9) von diesem pn-Übergang.

3. Thyristor nach Anspruch 1, dadurch gekennzeichnet, daß der erste Hilfsemitter (30) von einem Teilbereich (33) der angrenzenden Basis (29) umgeben ist, dessen Dotierungsgrad höher ist als der Dotierungsgrad des Teilbereiches dieser Basis (29), der den anschaltbaren zweiten Hilfsemitter (31) umgibt.

4. Thyristor nach Anspruch 1, dadurch gekennzeichnet, daß der erste Hilfsemitter (30) von einem Teilbereich (33) der angrenzenden Basis (29) umgeben ist, der eine größere Anzahl von Rekombinationszentren pro Raumeinheit aufweist als der Teilbereich dieser Basis (29), der den anschaltbaren zweiten Hilfsemitter (31) umgibt.

5. Thyristor nach einem der vorhergehenden Ansprüche, dadurch gekennzeichnet, daß der Halbleiterschalter aus einem Feldeffekttransistor besteht, der einen Randbereich des anschaltbaren zweiten Hilfsemitters (11), einen Randbereich des ersten Hilfsemitters (9) und einen diese beiden Randbereiche voneinander trennenden Teilbereich (12) der angrenzenden Basis (2) umfaßt, wobei dieser Teilbereich (12) von einem gegenüber dem Halbleiterkörper elektrisch isolierten Gate (13) überdeckt ist, das mit einem ersten Steuerspannungsanschluß (15) versehen ist.

6. Thyristor nach einem der Ansprüche 1 bis 4, dadurch gekennzeichnet, daß der Halbleiterschalter aus einem externen Feldeffekttransistor (42) besteht, dessen Source- bzw. Drainanschluß mit dem ersten Hilfsemitter (9) bzw. dem anschaltbaren zweiten Hilfsemitter (11) verbunden sind und dessen Gate mit einem zweiten Steuerspannungsanschluß (44) versehen ist.

7. Thyristor nach einem der vorhergehenden Ansprüche, dadurch gekennzeichnet, daß der anschaltbare zweite Hilfsemitter (11) aus einem Gebiet (25) des Halbleiterkörpers besteht, das eine in der angrenzenden Basis vorgesehene, von der Grenzfläche (8) des Halbleiterkörpers ausgehende Ausnehmung (26) umgibt und einen zu dieser Basis (2) entgegengesetzten Leitungstyp aufweist.

8. Thyristor nach einem der vorhergehenden Ansprüche, dadurch gekennzeichnet, daß der dem anschaltbaren zweiten Hilfsemitter (11) als Hauptemitter zugeordnete n-Emitter (1a, 1b) bzw. p-Emitter mit wenigstens einem steuerbaren Emitterkurzschluß (SE1) versehen ist, der ein mit der Kathode (6a) bzw. Anode verbundenes, erstes Halbleitergebiet (34) eines ersten Leitungstyps, ein mit der angrenzenden Basis (2) verbundenes zweites Halbleitergebiet (35) des ersten Leitungstyps und ein zwischen diesen Halbleitergebieten liegendes Halbleitergebiet (36) aufweist, und daß das Halbleitergebiet (36) von einem gegenüber dem Halbleiterkörper elektrisch isolierten Gate (37) überdeckt ist, das mit einem dritten Steuerspannungsanschluß (38) versehen ist.

9. Thyristor nach einem der vorhergehenden Ansprüche, dadurch gekennzeichnet, daß die an den anschaltbaren zweiten Hilfsemitter (11) angrenzende Basis (2) mit einer Zündelektrode (20) versehen ist, die einen Anschluß (21) für einen Zündstromkreis aufweist.

10. Thyristor nach einem der Ansprüche 5, 6 oder 8 und nach Anspruch 9, dadurch gekennzeichnet, daß der Anschluß (21) für den Zündstromkreis mit wenigstens einem der Steuerspannungsanschlüsse (15, 38, 44) verbunden ist.

11. Thyristor nach einem der vorhergehenden Ansprüche, dadurch gekennzeichnet, daß sich die Anode (5) und die Kathode (6, 6a, 6b) auf einander gegenüberliegenden Grenzflächen des Halbleiterkörpers befinden.

12. Verfahren zum Betrieb eines Thyristors nach einem der vorhergehenden Ansprüche, dadurch gekennzeichnet, daß zum Zünden desselben der Halbleiterschalter (9, 11, 13 bis 16 ; 42) leitend geschaltet wird.

13. Verfahren nach Anspruch 12, dadurch gekennzeichnet, daß zum Zünden des Thyristors dem Steuerspannungsanschluß (15, 44) des Halbleiterschalters bei einer Ausbildung desselben als n(p)-Kanal-Feldeffekttransistor des Anreicherungstyps und ggf. dem Steuerspannungsanschluß (38) des steuerbaren Emitterkurzschlusses (SE1) bei einer Ausbildung desselben als p(n)-Kanal-Feldeffekttransistor des Verarmungstyps jeweils ein positiver (negativer) Spannungsimpuls zugeführt wird.

**Claims**

1. A thyristor having a semiconductor body which contains an n-emitter (1) contacted by a cathode (6), a p-emitter (4) contacted by an anode (5), and two base layers (2, 3) of different conductivity type which are each adjacent to one of the emitters and are adjacent to one another, and which has a first auxiliary emitter (9) which provides an internal ignition amplification and forms a npn- or pnp-structure with the two base layers (2, 3), characterised in that a connectable second auxiliary emitter (11) is provided which can be conductively connected through a semiconductor switch (9, 11, 13, 14, 15, 16) to the first auxiliary emitter (9), and that the connectable second auxiliary emitter (11) forms, together with the two base layers (2, 3), a npn- or pnp-structure whose current amplification factor $(\alpha_{npn1})$, in the conducting state of the semiconductor switch and when a blocking voltage is connected, relative to the charge carriers emitted by the connectable second auxiliary emitter (11), is greater than the corresponding current amplification factor $(\alpha_{npn2})$ of the npn- or pnp-structure which consists of the first auxiliary emitter (9) and the two base layers (2, 3).

2. A thyristor as claimed in Claim 1, characterised in that the interval (D1) between the connectable second auxiliary emitter (11) and the pn-junction which is present between the two base layers (2, 3) is shorter than the interval (D2) between the first auxiliary emitter (9) and this pn-junction.

3. A thyristor as claimed in Claim 1, characterised in that the first auxiliary emitter (30) is surrounded by a part-zone (33) of the adjacent base (29), the level of doping of said part-zone (33) being higher than the level of doping of that part-zone of the base (29) which surrounds the connectable second auxiliary emitter (31).

4. A thyristor as claimed in Claim 1, characterised in that the first auxiliary emitter (30) is surrounded by a part-zone (33) of the adjacent base (29), the part-zone (33) having a greater number of recombination centres per unit volume than that part-zone of the base (29) which surrounds the connectable second auxiliary emitter (31).

5. A thyristor as claimed in one of the preceding Claims, characterised in that the semiconductor switch consists of a field effect transistor which comprises an edge zone of the connectable second auxiliary emitter (11), an edge zone of the first auxiliary emitter (9), and a part-zone (12) of the adjacent base (2), separating these two edge zones from one another, said part-zone (12) being covered by a gate (13) which is electrically insulated with respect to the semiconductor body and is provided with a first control voltage terminal (5).

6. A thyristor as claimed in one of Claims 1 to 4, characterised in that the semiconductor switch consists of an external field effect transistor (42), whose source and drain terminals are connected to the first auxiliary emitter (9) and to the connectable second auxiliary emitter (11) respectively and whose gate is provided with a second control voltage terminal (44).

7. A thyristor as claimed in one of the preceding Claims, characterised in that the connectable second auxiliary emitter (11) consists of a zone (25) of the semiconductor body, surrounding a recess (26) provided in the adjacent base and starting from the boundary surface (8) of the semiconductor body and which zone has a conductivity type which is opposite to that of the base (2).

8. A thyristor as claimed in one of the preceding Claims, characterised in that the n-emitter (1a, 1b) or p-emitter, which is assigned as main emitter to the connectable second auxiliary emitter (11), is provided with at least one controllable emitter short-circuit (SE1) which comprises a first semiconductor zone (34) of a first conductivity type which is connected to the cathode (6a) or anode as the case may be, a second semiconductor zone (35) of the first conductivity type which is connected to the adjacent base (2), and a semiconductor region (36) which is arranged between these semiconductor zones ; and that the semiconductor region (36) is covered by a gate (37) which is electrically insulated with respect to the semiconductor body and is provided with a third control voltage terminal (38).

9. A thyristor as claimed in one of the preceding Claims, characterised in that the base (2), which adjoins the connectable second auxiliary emitter (11), is provided with an ignition electrode (20) which has a terminal (21) for an ignition circuit.

10. A thyristor as claimed in one of Claims 5, 6 or 8 and in Claim 9, characterised in that the terminal (21) for the ignition circuit is connected to at least one of the control voltage terminals (15, 38, 44).

11. A thyristor as claimed in one of the preceding Claims, characterised in that the anode (5) and the cathode (6, 6a, 6b) are arranged on oppositely located boundary surfaces of the semiconductor body.

12. A method for operating a thyristor as claimed in one of the preceding Claims, characterised in that, in order to ignite the thyristor, the semiconductor switch (9, 11, 13 to 16 ; 42) is switched to the conductive state.

13. A method as claimed in Claim 12, characterised in that, in order to ignite the thyristor, the control voltage terminal (15, 44) of the semiconductor switch, where the latter consists of a n(p)-channel field effect transistor of the enhancement type, and, where appropriate, the control voltage terminal (38) of the controllable emitter short-circuit (SE1), where the latter consists of a p(n)-channel field effect transistor of the depletion type, are in each case supplied with a positive (negative) voltage pulse.

## Revendications

1. Thyristor comportant un corps semiconducteur, qui contient un émetteur (1) de type n, en contact avec une cathode (6), un émetteur (4) de type p en contact avec une anode (5) et deux couches de base (2, 3) possédant des types de conductivité différents, jouxtant respectivement l'un des émetteurs et étant réciproquement contigus, et qui comporte un premier émetteur auxiliaire (9) qui sert à réaliser l'amplification interne de l'amorçage et forme, avec les deux couches de base (2, 3), une structure npn ou pnp, caractérisé par le fait qu'il est prévu un second émetteur auxiliaire raccordable (11), qui est relié de façon conductrice au premier émetteur auxiliaire (9) par l'intermédiaire d'un interrupteur à semiconducteurs (9, 11, 13, 14, 15, 16), et que le second émetteur auxiliaire raccordable (11) forme, avec les deux couches de base (2, 3), une structure npn ou pnp, dont le facteur d'amplification de courant ($\alpha_{npn1}$). qui existe lorsque le commutateur à semiconducteurs est à l'état conducteur et la tension de blocage est appliquée et est rapporté aux porteurs de charge émis par le second émetteur auxiliaire raccordable (11), est supérieur au facteur d'amplification de courant correspondant ($\alpha_{npn2}$) de la structure npn ou pnp, qui est formée par le premier émetteur auxiliaire (9) et par les deux couches de base (2, 3).

2. Thyristor suivant la revendication 1, caractérisé par le fait que la distance (D1) entre le second émetteur auxiliaire raccordable (11) et la jonction pn présente entre les deux couches de base (2, 3) est inférieure à la distance (D2) entre le premier émetteur auxiliaire (9) et cette jonction pn.

3. Thyristor suivant la revendication 1, caractérisé par le fait que le premier émetteur auxiliaire (30) est entouré par une zone partielle (33) de la base contiguë (29), dont le degré de dopage est supérieur au degré de dopage de la zone partielle de cette base (29), qui entoure le second émetteur auxiliaire raccordable (31).

4. Thyristor suivant la revendication 1, caractérisé par le fait que le premier émetteur auxiliaire (30) est entouré par une zone partielle (33) de la base contiguë (29), qui possède un nombre de centres de recombinaison par unité d'espace, plus important que la zone partielle de cette base (29), qui entoure le second émetteur auxiliaire raccordable (31).

5. Thyristor suivant l'une des revendications précédentes, caractérisé par le fait que le commutateur à semiconducteurs est constitué par un transistor à effet de champ, qui entoure une zone marginale du second émetteur auxiliaire raccordable (11), une zone marginale du premier émetteur auxiliaire (9) et une zone partielle (12), séparant ces deux zones marginales l'une de l'autre, de la base contiguë (2), cette zone partielle (12) étant recouverte par une grille (13) isolée du point de vue électrique par rapport au corps semiconducteur et qui est munie d'une première borne de tension de commande (15).

6. Thyristor suivant l'une des revendications 1 à 4, caractérisé par le fait que l'interrupteur à semi-conducteurs est constitué par un transistor à effet de champ extérieur (42), dont la borne de source et de drain est raccordée au premier émetteur auxiliaire (9) ou au second émetteur auxiliaire raccordable (11) et dont la grille est munie d'une seconde borne de tension de commande (44).

7. Thyristor suivant l'une des revendications précédentes, caractérisé par le fait que le second émetteur auxiliaire raccordable (11) est constitué par une région (25) du corps semiconducteur, qui entoure un évidement (26) prévu dans la base contiguë et s'étendant à partir de la surface limite (8) du corps semiconducteur et possède un type de conductivité opposé à celui de cette base (2).

8. Thyristor suivant l'une des revendications précédentes, caractérisé par le fait que l'émetteur (1a, 1b) de type n ou l'émetteur de type p, qui est associé en tant qu'émetteur principal au second émetteur auxiliaire raccordable (18), comporte au moins un court-circuit d'émetteur commandable (SE1), qui comporte une première région semiconductrice (34), qui possède un premier type de conductivité et est reliée à la cathode (6a) ou à l'anode, une seconde région semiconductrice (35) possédant le premier type de conductivité et reliée à la base contiguë (2) et une région semiconductrice (36) située entre ces régions semiconductrices, et que la région semiconductrice (36) est recouverte par une grille (37) isolée du point de vue électrique par rapport au corps semiconducteur et qui est munie d'une troisième borne de tension de commande (38).

9. Thyristor suivant l'une des revendications précédentes, caractérisé par le fait que la base (2), qui jouxte le second émetteur auxiliaire raccordable (11), est muni d'une électrode d'amorçage (20), qui possède une borne (21) pour un circuit d'amorçage.

10. Thyristor suivant l'une des revendications 5, 6 ou 8 et la revendication 9, caractérisé par le fait que la borne (21) pour le circuit d'amorçage est reliée à au moins l'une des bornes de tension de commande (15, 38, 44).

11. Thyristor suivant l'une des revendications précédentes, caractérisé par le fait que l'anode (5) ou la cathode (6, 6a, 6b) sont situées sur des surfaces limites, situées réciproquement à l'opposé l'une de l'autre, du corps semiconducteur.

12. Procédé pour faire fonctionner un thyristor suivant l'une des revendications précédentes, caractérisé par le fait que pour l'amorçage de ce thyristor, le commutateur à semiconducteurs (9, 11, 13 à 16 ; 42) est branché à l'état conducteur.

13. Procédé suivant la revendication 12, caractérisé par le fait que pour l'amorçage du thyristor, une impulsion de tension respective positive (négative) est envoyée à la borne de tension de commande (15, 44) du commutateur à semiconducteurs dans le cas où ce dernier est réalisé sous la forme d'un transistor à effet de champ à canal n (ou p) du type à enrichissement et éventuellement à la borne de tension de commande (38) du court-circuit d'émetteur commandable (SE1) dans le cas où l'interrupteur est réalisé sous la forme d'un transistor à effet de champ à canal p (n), du type à appauvrissement.

## FIG 1

## FIG 2

FIG 3

FIG 4

# FIG 5